(19) Europäisches Patentamt
European Patent Office
Office européen des brevets

(11) **EP 2 698 933 A2**

(12) **EUROPEAN PATENT APPLICATION**
published in accordance with Art. 153(4) EPC

(43) Date of publication:
**19.02.2014 Bulletin 2014/08**

(51) Int Cl.:
**H04B 10/02** (0000.00)

(21) Application number: **11765082.0**

(22) Date of filing: **10.05.2011**

(86) International application number:
**PCT/CN2011/073867**

(87) International publication number:
**WO 2011/124164 (13.10.2011 Gazette 2011/41)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(71) Applicant: **Huawei Technologies Co., Ltd.**
**Guangdong 518129 (CN)**

(72) Inventors:
• **LIU, Dekun**
**Guangdong 518129 (CN)**

• **LIN, Huafeng**
**Guangdong 518129 (CN)**

• **XU, Zhiguang**
**Guangdong 518129 (CN)**

(74) Representative: **Epping - Hermann - Fischer Patentanwaltsgesellschaft mbH**
**Ridlerstrasse 55**
**80339 München (DE)**

(54) **SELF INJECTION LASER, WAVE DIVISION MULTIPLEXING PASSIVE OPTICAL NETWORK SYSTEM AND OPTICAL LINE TERMINAL**

(57)     A self-injection laser, a WDM-PON system and an optical line terminal. The self-injection laser includes a gain medium, an array waveguide grating AWG, a periodic filter and a reflection module. The gain medium is coupled to a branch port of the AWG, and the periodic filter is coupled to a common port of the AWG. The AWG is configured to multiplex an optical signal received from the gain medium via the branch port, and output the multiplexed optical signal via the common port. The periodic filter is configured to filter the optical signal output by the AWG, where at least a part of the filtered optical signal is reflected by the reflection module, and the reflected signal is returned back and injected to the gain medium. Through the self-injection laser, the WDM-PON system and the optical line terminal provided by the embodiments of the present invention, the problem of broadening of the spectra line can be effectively solved.

FIG. 1

EP 2 698 933 A2

**EP 2 698 933 A2**

**Description**

**TECHNICAL FIELD**

The present invention relates to the field of telecommunications network transmission systems, and in particular, to a self-injection laser, a wave division multiplexing passive optical network (WDM-PON, Wave Division Multiplexing Passive Optical Network) system and an optical line terminal.

**BACKGROUND**

With the growing demand for bandwidth of users, conventional copper broadband access systems face a bandwidth bottleneck; meanwhile, the optical fiber communication technology with a huge bandwidth capacity gradually gets mature, and the application costs are decreased. Therefore, optical fiber access networks have become strong competitors for next-generation broadband access networks, among which passive optical networks are more competitive.

Presently, among a variety of optical fiber access network solutions, WDM-PONs are concerned due to a more huge bandwidth capacity and information security similar to that of point to point communication. However, compared with optical fiber access networks such as EPONs (Ethernet over PONs) and gigabit passive optical networks (GPONs, Gigabit Passive Optical Networks) with a gigabit rate, the costs of WDM-PONs are very high, where the light source is a factor in the WDM-PON that has the greatest impact on the cost.

In order to solve the cost problem, the industry proposes a concept of WDM-PON colorless light source. The so-called colorless light source refers to that a transceiver module is independent of the wavelength, and the laser emission wavelength can automatically adapt to the port wavelength of an connected array waveguide grating (AWG, Array Waveguide Grating), so that the colorless light source can plug and play on any AWG port.

To implement a low-cost WDM-PON system, the industry proposes various solutions, for example, a solution based on a self-injection laser. Specifically, a current WDM-PON system based on a self-injection laser uses a channel of an AWG as a filter of the self-injection laser, so that the emission wavelength of each laser can automatically adapt to the channel of the AWG without using an expensive seed light source, and the structure is simple and has the potential of low cost.

However, the line width of the emission spectrum of the self-injection laser in the current WDM-PON system sharply broadens with the increase of the laser cavity length (that is, a distance from a user end to a remote end AWG). Therefore, the performance of the current self-injection laser and the WDM-PON system adopting the self-injection laser is low.

**SUMMARY**

Embodiments of the present invention provide a self-injection laser, a WDM-PON system and an optical line terminal, which can effectively solve the problem that the performance of a self-injection laser and a WDM-PON system is low in the prior art.

First, an embodiment of the present invention provides a self-injection laser, which includes: a gain medium, an array waveguide grating AWG, a periodic filter and a reflection module, where the gain medium is coupled to a branch port of the AWG, and the periodic filter is coupled to a common port of the AWG; the AWG is configured to multiplex an optical signal received from the gain medium via the branch port of the AWG, and output the multiplexed optical signal via the common port of the AWG; and the periodic filter is configured to filter the optical signal output by the AWG, where at least a part of the filtered optical signal is reflected by the reflection module, and the reflected signal is returned back and injected to the gain medium.

Further, an embodiment of the present invention provides a WDM-PON system, which includes: an optical line terminal OLT, a remote node RN and multiple optical network units ONUs having a gain medium, where the remote node includes an array waveguide grating AWG, a periodic filter and a reflection module, the AWG includes at least one common port and multiple branch ports, the common port is connected to the optical line terminal through a trunk optical fiber, the multiple branch ports are connected to the ONU through branch optical fibers, respectively, the periodic filter and the reflection module are connected to the common port of the AWG through a trunk optical fiber; and the gain medium of the ONU, the AWG, the periodic filter and the reflection module form the self-injection laser described above.

Further, an embodiment of the present invention provides an optical line terminal, which includes: multiple gain mediums, an array waveguide grating AWG, a periodic filter and a reflection module, where the AWG includes at least one common port and multiple branch ports, the multiple gain mediums are coupled to the branch ports of the AWG, respectively, the periodic filter is coupled to the common port of the AWG; the AWG is configured to multiplex optical signals received from the multiple gain mediums via the branch ports, and output the multiplexed optical signals via the

2

common port; and the periodic filter is configured to filter the optical signal output by the AWG, where at least a part of the filtered optical signal is reflected by the reflection module, and the reflected signal is returned back and injected to a corresponding gain medium.

It can be seen from the technical solutions described above, the embodiments of the present invention has the following advantages:

An emission spectrum of the self-injection laser is filtered by using the periodic filter, so that the emission wavelength of the self-injection laser is jointly determined by the periodic filter and the AWG. Due to the limitation of the wavelength of the periodic filter, the emission spectrum of self-injection laser does not sharply broaden with the increase of the laser cavity length, thereby effectively solving the problem of broadening of the spectra line of the self-injection laser, and improving the performance of the self-injection laser and the WDM-PON system.

## BRIEF DESCRIPTION OF DRAWINGS

To illustrate the technical solutions in the embodiments of the present invention more clearly, the following briefly introduces the accompanying drawings required for describing the embodiments. Apparently, the accompanying drawings in the following description show merely some embodiments of the present invention, and a person of ordinary skill in the art may still derive other drawings from these accompanying drawings without creative efforts.

FIG. 1 is a schematic diagram of a self-injection laser according to an embodiment of the present invention;

FIG. 2-a is a schematic diagram illustrating a principle of a Fabry-Perot Etalon Etalon filter according to an embodiment of the present invention;

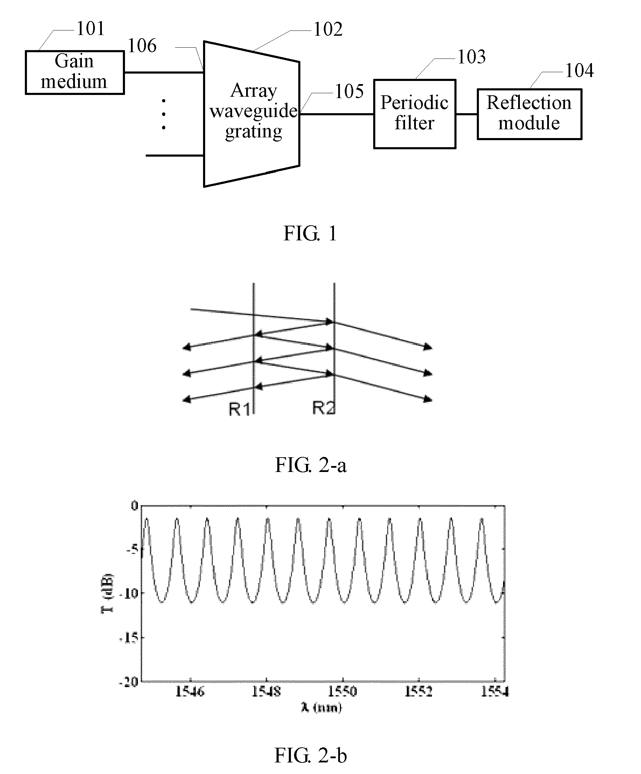

FIG. 2-b is a schematic diagram of a transmission curve of an Etalon filter according to an embodiment of the present invention;

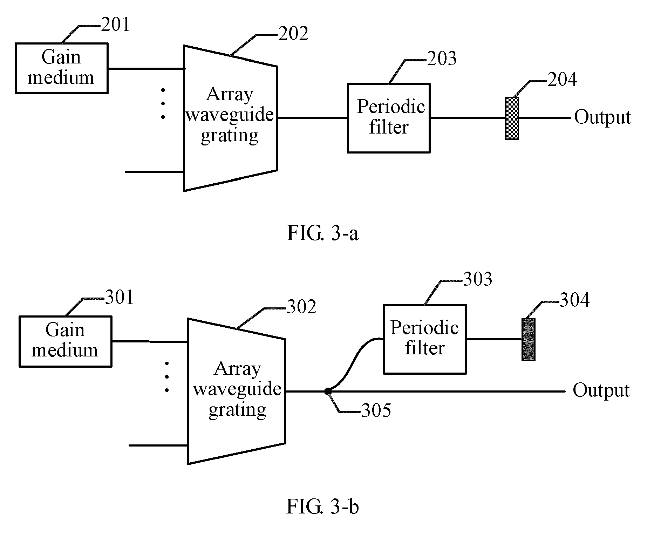

FIG. 3-a is a schematic diagram of a self-injection laser according to an embodiment of the present invention;

FIG. 3-b is another schematic diagram of a self-injection laser according to an embodiment of the present invention; and

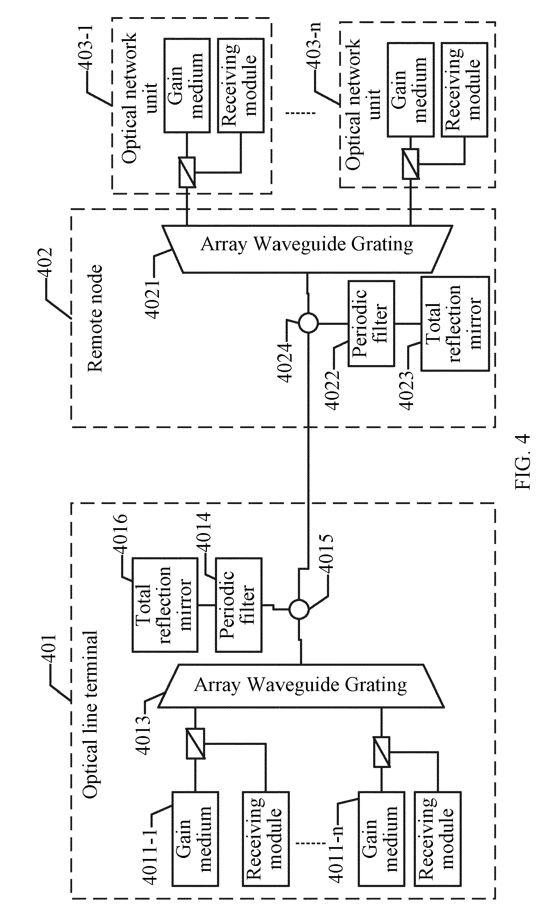

FIG. 4 is a schematic diagram of a WDM-PON system according to an embodiment of the present invention.

## DESCRIPTION OF EMBODIMENTS

Embodiments of the present invention provide a self-injection laser, a WDM-PON system and an optical line terminal, which are used for signal transmission in a wave division multiplexing passive optical network system, and can effective solve the problem of broadening of the spectra line of a self-injection laser in the prior art.

For better understanding of the technology, the self-injection laser, the WDM-PON system and the optical line terminal provided by the embodiments of the present invention are described in detail below with reference to the accompanying drawings.

Referring to FIG. 1, it is a schematic diagram of a self-injection laser provided by an embodiment of the present invention. The self-injection laser includes a gain medium 101, an array waveguide grating (AWG) 102, a periodic filter 103 and a reflection module 104 that are connected in sequence. The AWG 102 may include at least one common port 105 and multiple branch ports 106, the gain medium 101 is coupled to one of the branch ports 106 of the AWG 102, and the periodic filter 103 is directly or indirectly connected to the common port 106 of the AWG 102.

In the embodiment of the present invention, the gain medium 101 may be a wide-spectrum gain laser, and is configured to send a wide-spectrum optical signal to the one of the branch ports 106 of the AWG 102, where the wide-spectrum optical signal may be an amplified spontaneous emission (Amplified Spontaneous Emission, ASE) optical signal or other wide-spectrum optical signals. The AWG 102 is configured to multiplex the optical signal sent by the gain medium 101, and output the multiplexed optical signal via its common port 106. In the embodiment of the present invention, the periodic filter 103 may be a Fabry-Perot Etalon (Fabry-Perot Etalon, Etalon for short) filter or a periodic filter of other types, and is configured to filter the optical signal output by the common port 106 of the AWG 102, where a part of the filtered optical signal is reflected by the reflection module 104, and then is returned back along the same path and injected to the gain medium 101, so that after multiple such trips, resonant amplification is formed, thereby forming a wavelength oscillation cavity in the self-injection laser, and the other part of the filtered optical signal is transmitted, through an optical fiber, to a remote device such as an optical network unit (Optical Network Unit, ONU) located at a user end or an optical line terminal (Optical Line Terminal, OLT) located at a central office.

It should be noted that, the optical signal in the self-injection laser is transmitted by an optical fiber, for example, the common port 105 and the branch port 106 of the AWG 102 may be connected to a trunk optical fiber and a branch optical fiber, respectively, the gain medium 101 may be coupled to the branch port 106 of the AWG 102 through the branch optical fiber, and the periodic filter 103 and the reflection module 104 may be directly coupled to the trunk optical fiber or indirectly coupled to the trunk optical fiber through a beam splitter, and is connected to the common port 105 of the AWG 102 through the trunk optical fiber.

According to the embodiment of the present invention, in order to solve the problem of performance degradation resulting from broadening of the line width of the emission spectrum with the increase of the laser cavity length existing in the self-injection laser in the prior art, the periodic filter 103, for example, an Etalon filter utilizing the Fabry-Perot principle, is introduced into the self-injection laser through the filtering of the periodic filter 103, the wavelength of the emission spectrum of the self-injection laser is restricted to be around the center wavelength of a corresponding wavelength channel in the AWG 102, thereby improving the performance of the self-injection laser.

For better understanding of the technical solutions of the present invention, with an Etalon filter as an example, the working principle of the periodic filter 103 adopted by the self-injection laser according to the embodiment of the present invention and correspondence between a wavelength transmission curve and the wavelength channel of the AWG 102 is briefly introduced.

Referring to FIG. 2-a and FIG. 2-b, they are a schematic diagram illustrating a principle and a transmission curve of an Etalon filter according to an embodiment of the present invention, respectively. In an embodiment, the transmittance of the Etalon filter may be:

$$T = \frac{(1 - R_1 R_2 \alpha)^2}{(1 - R_1 R_2 \alpha)^2 + 4\sqrt{R_1 R_2 \alpha}\,\sin^2(\pi n L / \lambda)}\;;$$

where $R_1$ and $R_2$ are the reflectivity of two end surfaces of the Etalon filter, respectively, $\alpha$ is the propagation loss of the optical signal in one trip in the Etalon filter, n is the index of refraction of a medium in the Etalon filter, L is a distance between the front end surface and the back end surface of the Etalon filter, and $\lambda$ is the wavelength of the optical signal.

As shown in FIG. 2-b, the Etalon filter includes multiple periodic transmission peaks, and a distance between two adjacent transmission peaks in FIG. 2-b is a free spectral range of the filter. The free spectral range is mainly determined by the distance L between the two end surfaces of the Etalon filter, and the 3 db bandwidth of the transmission peak of the Etalon filter is mainly determined by the reflectivity of the two end surfaces and the loss in the cavity. It should be understood that, through appropriate design, the free spectral range of the Etalon filter is consistent with an interval of adjacent channels of the AWG 102, that is, the free spectral range corresponds to the interval, so that the center wavelength of each channel of the AWG 102 is located at the wavelength of the transmission peak of the Etalon filter, and the 3 dB bandwidth of the transmission peak of the Etalon filter can meet the demand of the system.

In the embodiment of the present invention, through appropriate design, the frequency interval of adjacent transmission peaks of the Etalon filter may be an integer fraction such as one times, a half, one third of the frequency interval of the channels of the AWG 102. When the line width of the AWG 102 is large, while the line width of the Etalon filter is small, an optical signal with a smaller line width is obtained after the optical signal is filtered by the Etalon filter, the optical signal with a smaller line width is reflected by the reflection module 104, and then the reflected signal is injected into the gain medium 101, so that after multiple such trips, resonance is formed, and the line width of the generated optical signal is correspondingly small. That is, through the filtering of the Etalon filter, the line width of the emission spectrum of the self-injection laser is restricted, thereby avoiding broadening of the line width with the cavity length. Therefore, even if the cavity length of the self-injection laser is large, the line width of the optical signal sent by the self-injection laser can be maintained in a narrow range, thereby avoiding the situation that the emission spectrum sharply broadens and the performance is severely degraded.

In the embodiment of the present invention, the AWG 102 in the self-injection laser may be a Gaussian AWG, a semi-Gaussian AWG, or a flattened AWG; optionally, the AWG 102 may also be replaced by a waveguide grating router (Waveguide Grating Router, WGR).

In the embodiment of the present invention, the gain medium 101 may be a reflective wide-spectrum gain laser having a low-reflectivity front end surface and a high-reflectivity back end surface and having gain amplification effect on the optical signal, for example, may be a Fabry Perot laser diode (FP-LD, Fabry Perot Laser Diode) or a reflective semiconductor optical amplifier (RSOA, Reflective Semiconductor Optical Amplifier).

In an embodiment of the present invention, the reflection module 104 in the self-injection laser may be a total reflection mirror or a partial reflection mirror.

When the reflection module 104 is a partial reflection mirror, a self-injection laser provided by an embodiment of the present invention may be shown in FIG. 3-a. Referring to FIG. 3-a, the self-injection laser includes: a gain medium 201, an AWG 202, a periodic filter (for example, an Etalon filter) 203 and a partial reflection mirror 204. The AWG 202 may include a common port and multiple branch ports, where the common port is connected to a trunk optical fiber, and the multiple branch ports are connected to branch optical fibers, respectively. In the embodiment of the present invention, the gain medium 201 is coupled to one branch port of the AWG 202 through the branch optical fiber, the periodic filter 203 and the partial reflection mirror 204 are directly coupled to a trunk optical fiber, where the partial reflection mirror 204 is connected to an output end of the periodic filter 203.

When the self-injection laser of the embodiment shown in FIG. 3-a works, an optical signal sent by the gain medium 201 is input to the branch port of the AWG 202, and the AWG 202 multiplexes the input optical signal and outputs the multiplexed optical signal via the common port. The periodic filter 203 filters the multiplexed optical signal output by the common port of the AWG 202, where one part of the filtered optical signal directly penetrates the partial reflection mirror 204 and is transmitted to a remote device such as an ONU at a user end or an OLT at a central office through the trunk optical fiber, and the other part of the filtered optical signal is reflected by the partial reflection mirror 204, the reflected signal is returned back along the same path and injected to the gain medium 201, so that after multiple such trips, resonant amplification is formed, thereby forming a wavelength oscillation cavity in the self-injection laser, and finally locking the wavelength of the optical signal transmitted by the self-injection laser at the wavelength of the transmission peak that is jointly determined by the AWG 202 and the periodic filter 203.

When the reflection module 104 is a total reflection mirror, a self-injection laser provided by the embodiment of the present invention may be shown in FIG. 3-b. Referring to FIG. 3-b, the self-injection laser includes: a gain medium 301, an AWG 302, a periodic filter (for example, an Etalon filter) 303 and a total reflection mirror 304. The AWG 302 may include a common port and multiple branch ports, where the common port is connected to a trunk optical fiber, and the multiple branch ports are connected to branch optical fibers, respectively. In the embodiment of the present invention, the gain medium 301 is coupled to one branch port of the AWG 302 through the branch optical fiber, the periodic filter 303 and the total reflection mirror 304 are coupled to the trunk optical fiber through a beam splitter 305, where the total reflection mirror 304 is connected to an output end of the periodic filter 303.

When the self-injection laser of the embodiment shown in FIG. 3-b works, an optical signal sent by the gain medium 301 is input to the branch port of the AWG 302, and the AWG 302 multiplexes the received optical signal and outputs the multiplexed optical signal via the common port. The beam splitter 304 further splits the multiplexed optical signal, where one part of the split optical signal is transmitted to a remote device through the trunk optical fiber, for example, transmitted to an ONU at a user end or an OLT at a central office, and the other part of the split optical signal is transmitted to the periodic filter 303 and the total reflection mirror 304. The periodic filter 303 filters the input optical signal, where the filtered optical signal is reflected by the total reflection mirror 304, and the reflected signal is returned back along the same path and injected to the gain medium 301, so that after multiple such trips, resonant amplification is formed, thereby forming a wavelength oscillation cavity in the self-injection laser, and finally locking the wavelength of the optical signal transmitted by the self-injection laser at the wavelength of the transmission peak that is jointly determined by the AWG 302 and the periodic filter 303.

It should be noted that, in the embodiment of the present invention, if a one-way-45-degree Faraday rotation cylinder is added before the partial reflection mirror 204 or the total reflection mirror 304, a Faraday rotator mirror (FRM, Faraday Rotator Mirror) is obtained. In this way, after an optical signal sent by the gain medium is reflected by the Faraday rotator mirror, the polarization direction is rotated by 90°. An optical signal in transverse electric (TE, transverse electric) mode sent by the wide-spectrum gain laser is reflected back by the FRM and becomes an optical signal in transverse magnetic (TM, transverse magnetic) mode, while a sent optical signal in TM mode is reflected back by the FRM and becomes an optical signal in TE mode. Based on this principle, the polarization gain dependency in the self-injection laser is lowered, which is beneficial to improvement of random polarization interference resistance of the system. Moreover, it can be seen from the description of the embodiment, the self-injection laser includes the Faraday rotator mirror, so that the problem of broadening of the spectra line can be solved, the polarization state of the self-injection fiber laser gets more stable, and details are not described herein again.

According to the self-injection laser provided by the embodiment of the present invention, the periodic filter (such as an Etalon filter) is used to filter the emission spectrum of the self-injection laser, because the line spectrum of the periodic filter is narrow, through filtering of the periodic filter, the line width of the emission spectrum of the self-injection laser is restricted, so as to prevent the line width from broadening with the cavity length. Therefore, even if the cavity length of the self-injection laser is large, for example, when the gain medium is far away from the AWG, the line width of the optical signal transmitted by the self-injection laser can still be maintained in a narrow range, thereby effectively solving the problem of broadening of the spectra line, and improving the performance of the self-injection laser.

Based on the self-injection laser provided by the foregoing embodiments, an embodiment of the present invention further provides a WDM-PON system. Referring to FIG. 4, it is a schematic structural diagram of a WDM-PON system provided by an embodiment of the present invention. The WDM-PON system includes an optical line terminal (OLT) 401, a remote node (Remote Node, RN) 402 and multiple optical network units (ONUs) 403. A remote AWG 4021 is set on the remote node 402, and the remote AWG 4021 includes a common port and N branch ports, where the common port of the remote AWG 4021 is connected to the OLT 401 through a trunk optical fiber, and the branch ports of the remote AWG 4021 are connected to the ONU 403 through branch optical fibers, respectively. Because the AWG 4021 has N branch ports, the WDM-PON system may include N ONUs 403, which are ONU 403-1, ..., and ONU 403-n, respectively. Each ONU 403 may include a gain medium, for example, a wide-spectrum gain laser such as a Fabry Perot laser diode (FP-LD) or a reflective semiconductor optical amplifier (RSOA). In the embodiment of the present invention, the OLT 401 is configured to send a downlink optical signal to the ONUs 403, and receive an uplink optical signal sent by the ONUs 403. The RN 402 is configured to perform wavelength demultiplexing on the downlink optical signal sent by the OLT 401 and provide the demultiplexed downlink optical signal to a corresponding ONU 403 through the branch optical fiber, and perform wavelength multiplexing on the uplink optical signal sent by the ONU 403 and send the multiplexed optical signal to the OLT 401 through the trunk optical fiber. The ONU 403 is configured to receive the downlink optical signal sent by the OLT 401 and send an uplink optical signal to the OLT 401.

In the embodiment of the present invention, the RN 402 further includes a periodic filter 4022 and a total reflection mirror 4023 that are connected to each other and connected to the common port of the AWG 4021 through the trunk optical fiber. The periodic filter 4022 may be an Etalon filter, and may be coupled to the trunk optical fiber through a beam splitter 4024, and the total reflection mirror 4023 may be connected to an output end of the periodic filter 4022. According to the embodiments of the self-injection lasers provided in FIG. 1 to FIG. 3, the gain medium in the ONU 403 and the AWG 4021, the periodic filter 4024 and the total reflection mirror 4023 in the RN 402 may form an external cavity self-injection laser. When the external cavity self-injection laser works, the AWG 4021 multiplexes the optical signal input by the gain medium of the ONU 403 via the branch port, and outputs the multiplexed optical signal via the common port. The multiplexed optical signal output via the common port is split by the beam splitter 4024, one part of the split optical signal serves as an uplink optical signal and is transmitted to the OLT 401 through the trunk optical fiber, and the other part of the split optical signal is input to the periodic filter 4022 and the total reflection mirror 4023. The periodic filter 4022 filters the input optical signal, where the filtered optical signal is reflected by the total reflection mirror 4023, and the reflected signal is returned back along the same path and injected to the gain medium of the ONU 403, so that after multiple such trips, resonant amplification is formed, thereby forming a self-injection laser resonant cavity between the RN 402 and the ONU 403, and finally locking the wavelength of the uplink optical signal transmitted by the ONU 403 at the wavelength of the transmission peak that is jointly determined by the AWG 4021 and the periodic filter 4022.

In the embodiment of the present invention, the OLT 401 may include a gain medium 4011, an AWG 4013, a periodic filter (for example, an Etalon filter) 4014 and a total reflection mirror 4016. The AWG 4013 includes a trunk port and N branch ports, where the trunk port is connected to the RN 402 through a trunk optical fiber, and the branch ports each are respectively connected to the gain medium 4011. Because the AWG 4013 has N branch ports, the OLT 401 may include N gain mediums 4011, and the gain medium 4011 may be a wide-spectrum gain laser such as a Fabry Perot laser diode (FP-LD) or a reflective semiconductor optical amplifier (RSOA). Taking the RSOA as an example, the N gain mediums 4011 are an RSOA 4011-1, ..., an RSOA 4011-n, respectively. Moreover, the periodic filter 4014 and the total reflection mirror 4016 may be coupled to the trunk optical fiber through a beam splitter 4015.

In the self-injection laser according to the embodiments in FIG. 1 to FIG. 3, in the WDM-PON system shown in FIG. 4, any one of the gain mediums 4011 in the OLT 401 may form a self-injection laser together with the AWG 4013, the periodic filter 4014 and the total reflection mirror 4016 in the OLT 401. When the self-injection laser in the OLT 401 works, the AWG 4013 multiplexes the optical signal input by the gain medium 4011 via the branch port, and outputs the multiplexed optical signal via the common port, where the multiplexed optical signal output via the common port is split by the beam splitter 4015, one part of the split optical signal serves as a downlink optical signal and is transmitted to the RN 402 through a trunk optical fiber, and the other part of the split optical signal is input to the periodic filter 4014 and the total reflection mirror 4016. In the embodiment of the present invention, the periodic filter 4014 filters the input optical signal, where the filtered optical signal is reflected by the total reflection mirror 4016, and the reflected signal is returned back along the same path and injected to the gain medium 4011, so that after multiple such trips, resonant amplification is formed, thereby forming a self-injection laser resonant cavity in the OLT 401, and finally locking the wavelength of the downlink optical signal transmitted by the OLT 401 at the wavelength of the transmission peak that is jointly determined by the AWG 4013 and the periodic filter 4014.

In a specific embodiment, the AWG 4021 and the AWG 4023 may be a flattened AWG, a Gaussian AWG or a semi-Gaussian AWG; or, the AWG 102 may be replaced by a WGR. The frequency interval between adjacent transmission peaks of the periodic filter 4022 may be an integer fraction of the frequency interval of the channels of the AWG 4021, and the frequency interval between adjacent transmission peaks of the periodic filter 4014 may be an integer fraction of the frequency interval of the channel of the AWG 4013.

In the embodiment of the present invention, a Fabry-Perot Etalon filter is added in the self-injection laser of the WDM-PON system, so that the line width of the signal that passes through the AWG and is filtered by the Fabry-Perot Etalon filter does not sharply broaden with the increase of the distance to the remote AWG, and can still be maintained in a narrow range, thereby improving the performance of the system.

It should be noted that, in the embodiment of the present invention, the WDM-PON system is introduced with the situation that the reflection module included in the self-injection laser in the WDM-PON system is a total reflection mirror as an example, and in actual application, a partial reflection mirror or a Faraday rotator mirror may also be used in the self-injection laser. As for the structural diagram of the WDM-PON system, reference can be made to relevant context in the embodiment shown in FIG. 3, and details are not described herein again.

It should be understood that, the embodiments described above are only a part rather than all of the embodiments of the present invention. All other embodiments obtained by persons of ordinary skill in the art based on the embodiments of the present invention without creative efforts shall fall within the protection scope of the present invention.

Persons of ordinary skill in the art should understand that all or a part of the steps of the method according to the embodiments of the present invention may be implemented by a program instructing relevant hardware. The program may be stored in a computer readable storage medium. When the program is run, the steps of the method according to the embodiments of the present invention are performed. The storage medium may be a Read-Only Memory, a magnetic disk or an optical disk.

The self-injection laser, the WDM-PON system and the optical line terminal provided by the present invention are described in detail above. Persons of ordinary skill in the art can make variations and modifications to the present invention in terms of the specific implementations and application scopes according to the ideas of the present invention. Therefore, the specification shall not be construed as a limit to the present invention.

**Claims**

1. A self-injection laser, comprising: a gain medium, an array waveguide grating AWG, a periodic filter and a reflection module; wherein
   the gain medium is coupled to a branch port of the AWG, and the periodic filter is coupled to a common port of the AWG;
   the AWG is configured to multiplex an optical signal received from the gain medium via the branch port of the AWG, and output the multiplexed optical signal via the common port of the AWG; and
   the periodic filter is configured to filter the optical signal output by the AWG, wherein at least a part of the filtered optical signal is reflected by the reflection module, and the reflected signal is returned back and injected to the gain medium.

2. The self-injection laser according to claim 1, wherein the periodic filter has multiple transmission peaks, and a center wavelength of a wavelength channel of the AWG is located at wavelengths of the transmission peaks of the periodic filter.

3. The self-injection laser according to claim 2, wherein a frequency interval between adjacent transmission peaks of the periodic filter is an integer fraction of a frequency interval of the wavelength channel of the AWG.

4. The self-injection laser according to claim 1, wherein a free spectral range of the periodic filter is consistent with an interval between adjacent wavelength channels of the AWG.

5. The self-injection laser according to any one of claims 1 to 4, wherein the periodic filter is a Fabry-Perot Etalon Etalon filter.

6. The self-injection laser according to claim 5, wherein the reflection module comprises a partial reflection mirror or a Faraday rotator mirror.

7. The self-injection laser according to claim 5, wherein the reflection module comprises a total reflection mirror, and the self-injection laser further comprises a beam splitter, wherein the periodic filter and the reflection module are coupled to the common port of the AWG through the beam splitter, and the total reflection mirror is connected to an output end of the periodic filter.

8. A wave division multiplexing passive optical network WDM-PON system, comprising: an optical line terminal OLT, a remote node RN and multiple optical network units ONUs having a gain medium; wherein
   the remote node comprises an array waveguide grating AWG, a periodic filter and a reflection module, the AWG comprises at least one common port and multiple branch ports, the common port is connected to the optical line terminal through a trunk optical fiber, the multiple branch ports are connected to the ONU through branch optical fibers, respectively, and the periodic filter and the reflection module are connected to the common port of the AWG through the trunk optical fiber; and
   the gain medium of the ONU, the AWG, the periodic filter and the reflection module form the self-injection laser according to any one of claims 1 to 7.

9. An optical line terminal, comprising: multiple gain mediums, an array waveguide grating AWG, a periodic filter and a reflection module, wherein the AWG comprises at least one common port and multiple branch ports, the multiple gain mediums are coupled to the branch ports of the AWG, respectively, the periodic filter is coupled to the common port of the AWG;

the AWG is configured to multiplex an optical signal received from the multiple gain mediums via the branch port, and output the multiplexed optical signal via the common port; and

the periodic filter is configured to filter the optical signal output by the AWG, wherein at least a part of the filtered optical signal is reflected by the reflection module, and the reflected signal is returned back and injected to a corresponding gain medium.

10. The optical line terminal according to claim 9, wherein the periodic filter has multiple transmission peaks, and a center wavelength of a wavelength channel of the AWG is located at wavelengths of the transmission peaks of the periodic filter.

11. The optical line terminal according to claim 10, wherein a frequency interval between adjacent transmission peaks of the periodic filter is an integer fraction of a frequency interval of the wavelength channel of the AWG.

12. The optical line terminal according to claim 9, wherein a free spectral range of the periodic filter is consistent with an interval between adjacent wavelength channels of the AWG.

13. The optical line terminal according to any one of claims 9 to 12, wherein the periodic filter is a Fabry-Perot Etalon Etalon filter.

FIG. 1

FIG. 2-a

FIG. 2-b

FIG. 3-a

FIG. 3-b

FIG. 4